# EUROPEAN PATENT SPECIFICATION

(11) **EP 0 720 056 B1**
(45) Date of publication and mention of the grant of the patent: **06.10.1999**
(21) Application number: 95309448.9
(22) Date of filing: 27.12.1995
(51) Int. Cl.: G03F 7/20

(54) **Illumination system and scan type exposure apparatus**
Beleuchtungssystem und Abtastbelichtungsapparat
Système d'illumination et appareil d'exposition par balayage

(30) Priority: 28.12.1994 JP 32745094
(43) Date of publication of application: 03.07.1996
(73) Proprietor: CANON KABUSHIKI KAISHA, Tokyo (JP)
(72) Inventor: Ozawa, Kunitaka, Ohta-ku, Tokyo (JP); Sakamoto, Eiji, Ohta-ku, Tokyo (JP); Takahashi, Kazuhiro, Ohta-ku, Tokyo (JP); Fukagawa, Youzou, Ohta-ku, Tokyo (JP)
(74) Representative: Beresford, Keith Denis Lewis

(56) References cited:
- US-A- 4 822 975
- US-A- 5 289 231
- US-A- 5 291 240

## Description

### FIELD OF THE INVENTION AND RELATED ART

This invention relates to an illumination system and, more particularly, to an illumination system suitably usable in manufacture of devices such as semiconductor devices (ICs, LSIs, etc.), liquid crystal devices, image pickup devices (CCDs, etc.) or magnetic heads. In another aspect, the invention is concerned with an exposure apparatus, more particularly, a scan type exposure apparatus, suitably usable in the manufacture of microdevices such as described above.

Generally, scan type exposure apparatuses use a continuous emission type light source such as a Hg lamp, for example. Since the pattern resolution is proportional to the wavelength of illumination light, use of a light source which is able to emit light in the deep ultraviolet region, of shorter wavelength, is desired in order to meet further increases of integration of a circuit. While light from a Hg lamp in the deep ultraviolet region may be used, it is not easy to obtain an output enough for use in an exposure apparatus. On the other hand, a sufficient output of short wavelength light in the deep ultraviolet region may be provided by an excimer laser, and use of the same has been considered effective.

In an occasion where a scanning exposure process is to be performed with an exposure apparatus having, as a light source, an excimer laser which is a pulse emission laser, in order to attain a desired exposure amount, the scan speed of a reticle and a wafer should be determined so that the wafer is irradiated with pulse light by times corresponding to the desired exposure amount. Hereinafter, this "desired exposure amount" will be referred to as "target integration exposure amount".

In a case where the exposure process is performed with pulse light having a rectangular intensity distribution with respect to the scan direction and where the width of illumination range by the pulse light upon the reticle (or wafer) in the scan direction corresponds to the product of M x N (M is the movement amount of the reticle (or wafer) per pulse and N is an integer), every exposure zone is irradiated with the same number of light pulses. Thus, there does not occur non-uniformness in exposure. However, if the exposure process is performed with a scan speed which does not satisfy the above-mentioned relation, overlapping occurs at the pulse light boundary. This causes exposure non-uniformness of a quantity corresponding to one pulse. Such non-uniformness corresponding to one pulse might be disregarded if the number of pulses to be used for the exposure is large (e.g. more than several hundreds). However, if the exposure pulse number is made smaller for enhanced throughput, the exposure non-uniformness corresponding to one pulse raises a problem.

US-A-4 822 975 discloses a method and an apparatus for scanning exposure with a pulsed laser beam having a rectangular cross section with a trapezoidal intensity distribution along the length of the rectangle and a triangular intensity distribution across the width of the rectangle.

### SUMMARY OF THE INVENTION

It is a concern of the present invention to provide an illumination system suitably usable in a scan type exposure apparatus, for example, having a light source of pulse emission type, such as an excimer laser, for example, by which illumination system the exposure non-uniformness such as described above can be reduced.

In accordance with a first aspect of the present invention, there is provided an illumination system for relatively and scanningly moving an article to be illuminated relative to an illumination region to be defined by the pulse light; wherein, in a light intensity distribution defined in the illumination region with respect to a scan direction, the light intensity changes non-linearly from at least one end portion to a highest light intensity point in the distribution; wherein the light intensity distribution includes a first point at said one end portion, a second point whereat light intensity increase changes, a third point whereat light intensity increase changes, and a fourth point whereat the light intensity is highest; and wherein at least one of the width Wa between the first and second points and the width Wb between the third and fourth points substantially corresponds to or is greater than the relative movement amount between the illumination region and the article per pulse.

In one preferred form of this aspect of the present invention, the light intensity distribution may have a symmetrical shape with respect to the scan direction. The second and third points may be coincident with each other. The widths Wa and Wb may be equal to each other. Portions of the light intensity distribution corresponding to the widths Wa and Wb may be able to be approximated by a quadratic curve.

The light intensity distribution in the illumination region with respect to the scan direction may be defined by a masking blade disposed at a position out of a plane which is optically conjugate with the article. Alternatively, it may be defined by a filter for determining the light intensity distribution in the illumination region. The filter may be disposed at a position slightly deviated from a plane which is optically conjugate with the article. The filter may have a transmissivity changing with the position of light incidence on said filter. The filter may comprise a diffraction grating adapted to provide zeroth order diffraction light whose light intensity changes with the position of light incidence on said grating. Blocking means may be provided to block diffraction light other than the zeroth order diffraction light.

The illumination system may include control means for controlling the emission time moment of a light pulse on the basis of the light quantity provided by a preceding light pulse. The pulse light may comprise excimer laser light.

In accordance with a second aspect of the present invention, there is provided an illumination system for relatively and scanningly moving an article to be illuminated relative to an illumination region to be defined by the pulse light; wherein a light intensity distribution defined in the illumination region with respect to a scan direction has a trapezoid like shape in which the light intensity at at least one of four corners changes along a smooth curve; and wherein the width of at least one portion of the light intensity distribution in which the light intensity changes along a smooth curve corresponds to or is greater than the relative movement amount between the illumination regi-on and the article per pulse.

These and other features and advantages of the present invention will become more apparent upon a consideration of the following description of the preferred embodiments of the present invention taken in conjunction with the accompanying drawings.

### BRIEF DESCRIPTION OF THE DRAWINGS

Figure 1 is a schematic view of a scan type exposure apparatus according to an embodiment of the present invention.

Figure 2 is a schematic view for explaining an illumination region on a wafer, defined by slit-like illumination light.

Figure 3 is a schematic view for explaining displacement of a point on a wafer relative to the illumination region.

Figure 4 is a graph for explaining the basic concept of a light intensity distribution of pulse light, according to the present invention.

Figure 5 is a graph for explaining an example of light intensity distribution of pulse light, according to the present invention.

Figure 6 is a graph for explaining another example of light intensity distribution of pulse light, according to the present invention.

Figure 7 is a graph for explaining a further example of light intensity distribution of pulse light, according to the present invention.

Figure 8 is a graph for explaining a still further example of light intensity distribution of pulse light, according to the present invention.

Figure 9 is a graph for explaining a yet further example of light intensity distribution of pulse light, according to the present invention.

Figure 10 is a graph for explaining a light intensity distribution of pulse light, of trapezoidal shape.

Figure 11 is a graph for explaining a still further example of light intensity distribution of pulse light, according to the present invention.

Figure 12 is a graph for explaining the relationship between the pulse number and the exposure non-uniformness of pulse light having a light intensity distribution such as shown in Figure 10.

Figure 13 is a graph for explaining the relationship between the pulse number and the exposure non-uniformness of pulse light having a light intensity distribution such as shown in Figure 11.

Figure 14 is a schematic view for explaining the manner of setting a light intensity distribution with use of a gradation filter, in accordance with an embodiment of the present invention.

Figure 15 is a schematic view for explaining the manner of setting a light intensity distribution with use of a grating filter, in accordance with an embodiment of the present invention.

Figure 16 is a graph for explaining integration of exposure amount, in a system having a continuous emission type light source.

Figure 17 is a graph for explaining integration of exposure amount, with light pulses of constant light quantity.

Figure 18 is a graph for explaining integration of exposure amount, with light pulses of irregular light quantity.

Figure 19 is a graph for explaining integration of exposure amount, in accordance with an exposure amount controlling method according to an embodiment of the present invention.

Figure 20 is a flow chart of semiconductor device manufacturing processes.

Figure 21 is a flow chart for explaining details of a wafer process in the sequence of Figure 20.

### DESCRIPTION OF THE PREFERRED EMBODIMENTS

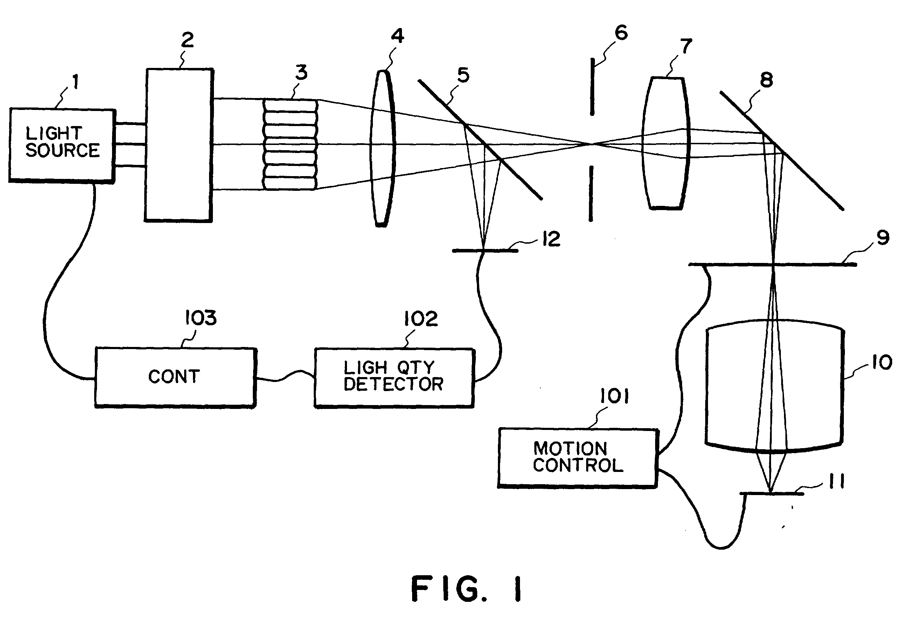

Figure 1 is a schematic view of a scan type projection exposure apparatus according to an embodiment of the present invention, which is suitably usable in the manufacture of microdevices such as semiconductor devices (e.g., ICs or LSIs), liquid crystal devices, image pickup devices (e.g., CCDs) or magnetic heads, for example.

In Figure 1, light from a pulse light source 1 such as an excimer laser, for example, is shaped into a desired shape by a beam shaping optical system 2. The light from the beam shaping optical system 2 is directed to the light entrance surface of an optical integrator 3, such as a fly's eye lens. The fly's eye lens comprises a combination of small lenses, and it defines a plurality of secondary light sources in the vicinity of the light exit surface of the integrator.

Denoted at 4 is a condenser lens which serves to perform Koehler illumination of a masking blade 6 with light from the secondary light sources of the optical integrator 3. The masking blade 6 is disposed out of an optically conjugate relation with a reticle 9, with respect to an imaging lens 7 and a mirror 8. Once the shape of the opening of the masking blade 6 is determined, the shape and size of the illumination region upon the reticle to be provided by pulse light is determined. The illumination region upon the reticle has an oblong slit-like shape having its minor direction (widthwise direction) set along the scan direction of the reticle 9.

Denoted at 10 is a projection optical system for projecting, in a reduced scale, a circuit pattern of a reticle 9 onto a wafer 11. Denoted at 101 is a motion controlling system for moving, through a driving mechanism (not shown), the reticle 9 and the wafer 11 accurately at a constant speed and with the same ratio as the projection magnification of the projection optical system 10. Denoted at 12 is a light quantity detector. It serves to indirectly monitor the exposure amount upon the wafer by each pulse, by monitoring a portion of the pulse light divided by a half mirror 5. Control system 103 serves to control the timing of emission of the pulse light source in accordance with the measured exposure amount as calculated by a light quantity calculator 102.

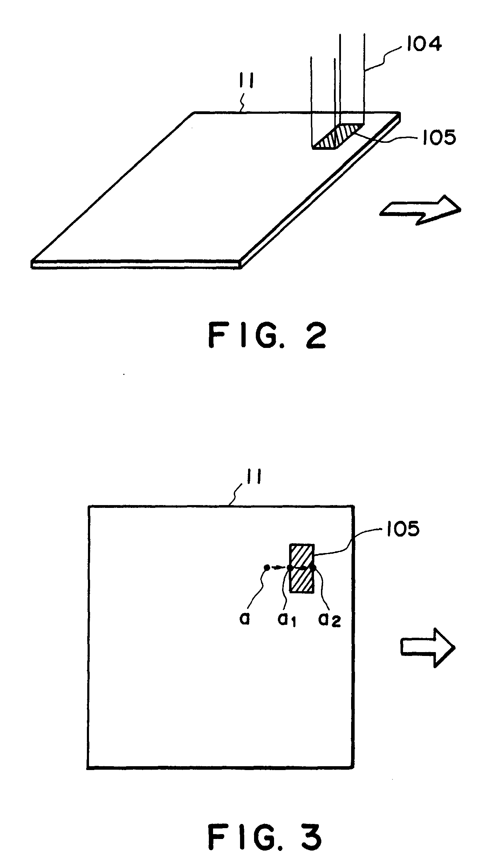

Figure 2 illustrates the wafer 11 as moving, during the exposure process, in a direction of an arrow, perpendicular to the light path of illumination light 104 from the reticle 9, which light bears information about the pattern of the reticle 9. With the movement of the wafer 11 in the direction of the arrow of Figure 2, the wafer 11 surface is scanningly exposed with the illumination region 105 defined by the slit-like light 104. Figure 3 illustrates the wafer 11 of Figure 2, as seen in the direction of illumination (i.e., from above), and it shows that with the motion of the wafer 11 a particular point a on the wafer 11 displaces across the illumination region 105 (a → a₁ → a₂). As the point a comes to the position a₁, the exposure of the point a starts. As the point a comes to the position a₂, the exposure of the point a ends.

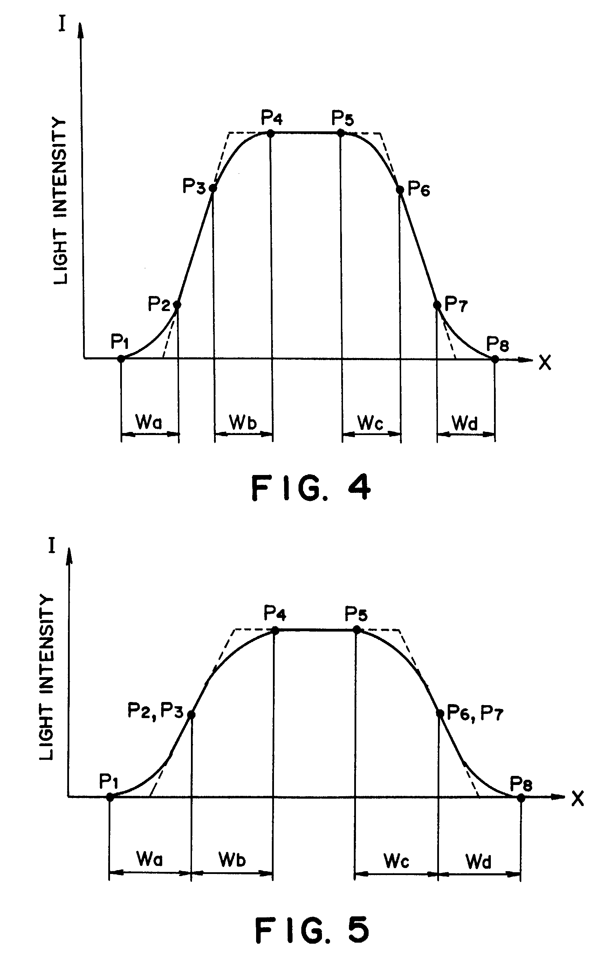

Figure 4 is a schematic view for explaining the basic concept of light intensity distribution of pulse light in the illumination region and with respect to the scan direction, according to the present invention. In the drawing, a reference character Wa denotes the width from a first point P₁ which is at a left-hand side end portion, as viewed in the drawing, to asecond point P₂ whereat the manner of light intensity increase changes. A reference character Wb denotes the width from a third point P₃ whereat the manner of light intensity increase changes to a fourth point P₄ whereat the light intensity is highest. A reference character Wc denotes the width from a fifth point P₅ whereat the light intensity is highest to a sixth point P₆ whereat the manner of light intensity decrease changes. A reference character Wd denotes the width from a seventh point P₇ whereat the manner of light intensity decrease changes to an eighth point P₈ which is at a right-hand side end portion.

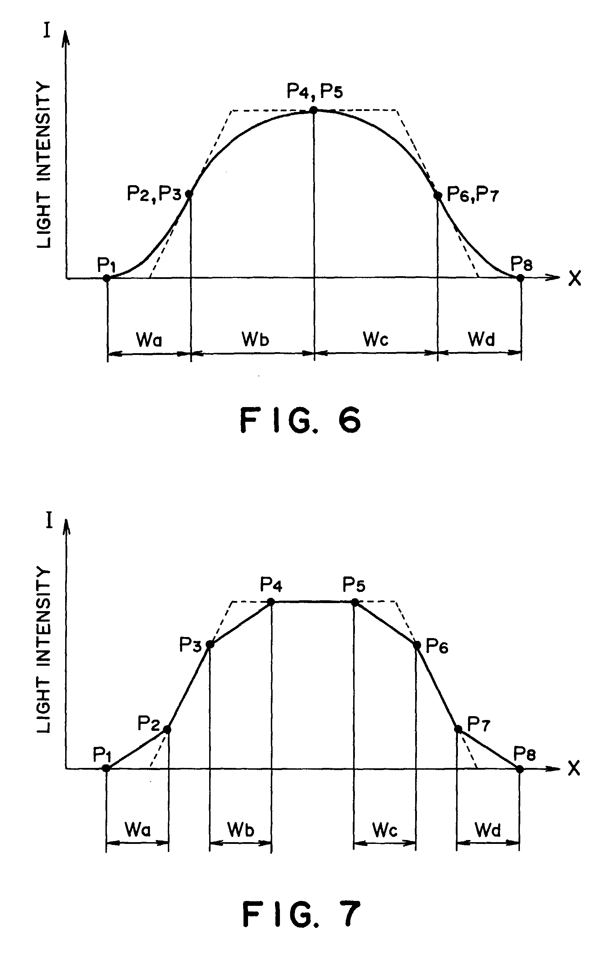

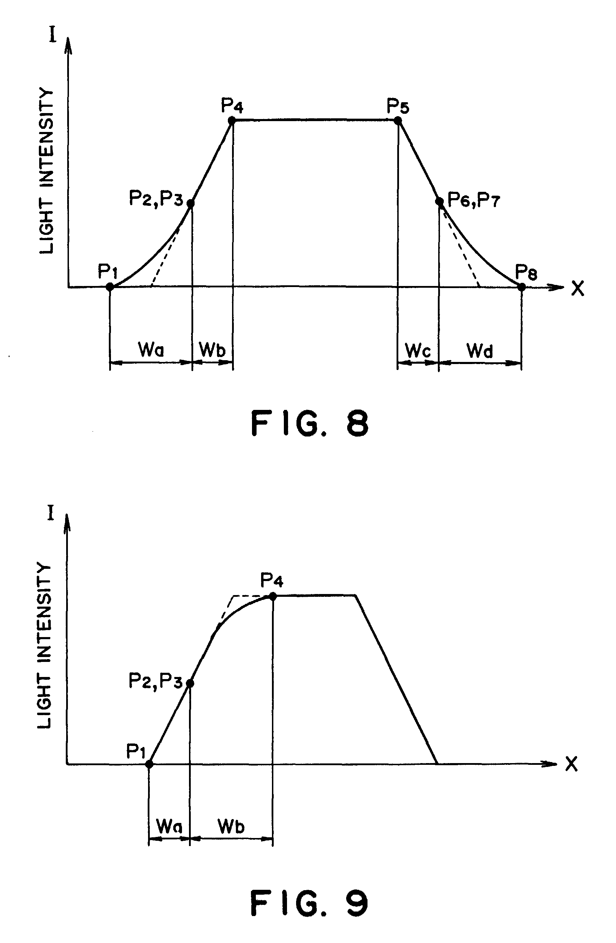

In addition to the one illustrated in Figure 4, those light intensity distributions such as shown in Figures 5 - 9, for example, are applicable. Figure 5 shows an example where the points whereat the light intensity increase or decrease changes are coincident with each other (points P₂ and P₃; points P₆ and P₇). Figure 6 shows an example where, in addition to the condition of Figure 5, the highest light intensity points are coincident with each other (points P₄ and P₅). Figure 7 shows an example where the light intensity changes straight. Figures 8 and 9 show examples corresponding to combinations of the light intensity distributions described above. In addition to those examples, various forms of light intensity distributions are applicable within the scope of the present invention.

The point whereat the light intensity increase or decrease changes, mentioned above, refers to such point across which a function that represents changes in light intensity changes or to a point of inflection where the function is unchanged.

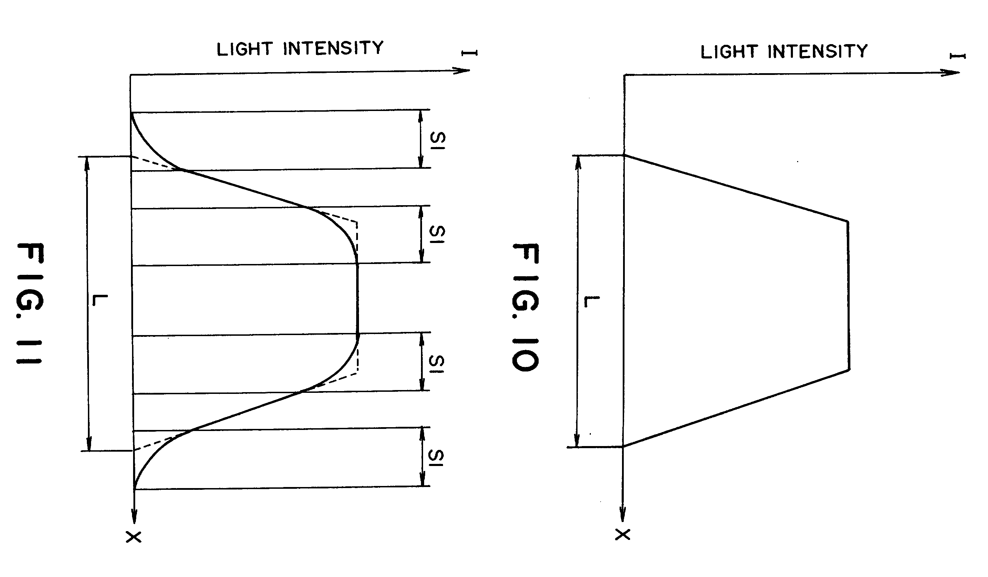

Figure 10 shows a light intensity distribution of pulse light, of trapezoidal shape, having been used conventionally. Figure 11 shows a light intensity distribution of pulse light, according to an embodiment of the present invention.

The light intensity distribution of the pulse light shown in Figure 10 has a regular trapezoidal shape (with slants of the same length), having a top width of 3 mm and a bottom width of 5 mm, both upon the wafer 11 surface. As compared therewith, the light intensity distribution of the pulse light of the Figure 11 embodiment has such a shape wherein corners of the trapezoidal light intensity distribution of the pulse light of Figure 10 are rounded along a quadratic curve. In the light intensity distribution of the pulse light of Figure 11, the widths corresponding to Wa, Wb, Wc and Wd in Figure 4 are all the same, and they are denoted by the same reference character S₁. In this embodiment, the width S₁ is 0.25 mm upon the wafer 11 surface.

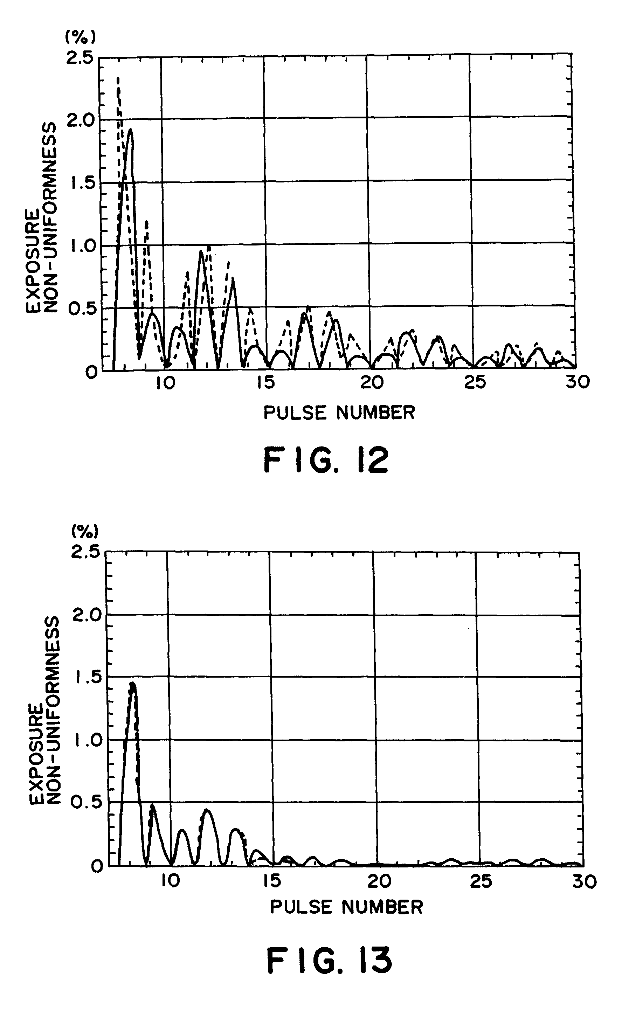

Figure 12 illustrates the relationship between the exposure non-uniformness and the pulse number, in a case where pulse light having a light intensity distribution of the Figure 10 example is used. Figure 13 illustrates the relationship between the exposure non-uniformness and the pulse number, in a case where pulse light having a light intensity distribution of the Figure 11 embodiment is used. The term "pulse number" corresponds to a value resulting from dividing the width L of the illumination region on the wafer 11 surface by the movement amount of the wafer 11 per pulse, and it represents an average number of pulses with which a certain point in the exposure region is irradiated. Thus, the pulse number is not always an integral number. In the pulse light having an intensity distribution such as shown in Figure 11, the width L is defined as illustrated in the drawing.

In Figures 12 and 13, curves of solid line depict positive (+) side non-uniformness with reference to a target integration exposure amount, and curves of broken line depict negative (-) side non-uniformness with reference to the target integration exposure amount.

Comparing the graph of Figure 13 with the graph of Figure 12, it is clear that the exposure non-uniformness is generally reduced in the case where the pulse light of the light intensity distribution of Figure 11, than in the case where the pulse light of the light intensity distribution of Figure 10.

Also, in Figure 13, it is seen that in the pulse number range from about 20 (twenty) to more than 20 the exposure non-uniformness is reduced considerably. As the pulse number is equal to 20, the movement amount of the wafer 11 per pulse is equal to 0.25 mm. This is equal to the width S₁ in this embodiment. Namely, the pulse number range in Figure 13 not lower than a pulse number 20, corresponds to a movement amount range in which the movement amount per pulse is not larger than 0.25 mm. Thus it is seen that, when the width S₁ is approximately equal to or not less than the movement amount per pulse, the exposure non-uniformness is reduced considerably.

This embodiment uses a masking blade 6 having two sets of orthogonal and variable slits. In this embodiment, of these slits, an image of the two variable slits in the direction serviceable to determine the width of the illumination region in the scan direction, can be defocused. Thus, the value of the width S₁ can be set as desired.

In this embodiment, an image of the opening of the masking blade 6 is projected through the imaging lens 7 onto the patterned surface of the reticle 9. However, use of the imaging lens 7 is not always necessary. As an example, the masking blade 6 may be disposed just before the reticle 9.

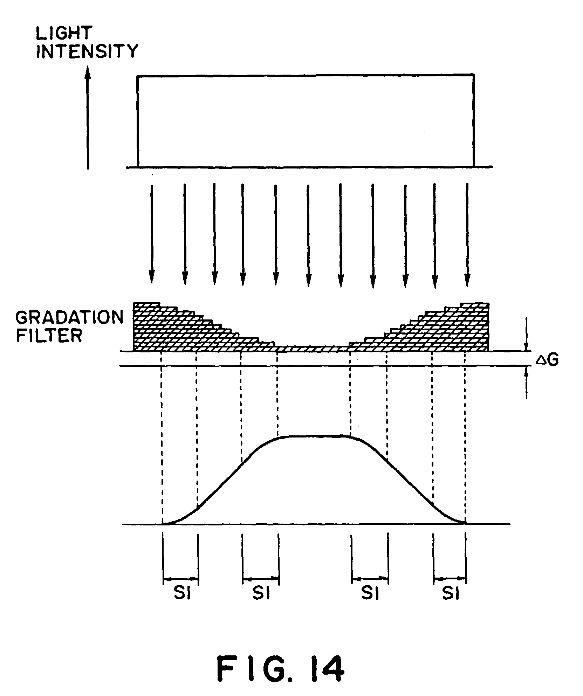

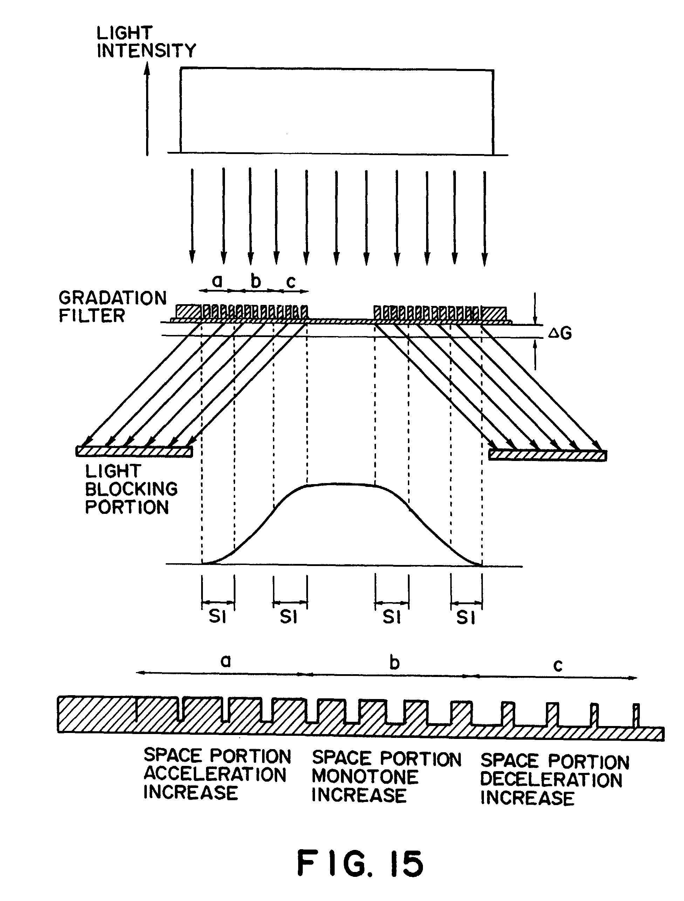

Also, the manner of setting the light intensity distribution is not limited to the above-described example. An alternative is use of a gradation filter such as shown in Figure 14, at the position of the masking blade 6. A further alternative is use of a grating filter such as shown in Figure 15.

Gradation filter may be provided by partially superposing films, having a predetermined transmissivity or transmissivities, with each other such as illustrated in Figure 14, so that the transmissivity changes with the position of light incidence. Thus, the gradation filter may provide a desired shape of light intensity distribution.

Grating filter may comprise an amplitude type diffraction grating and, in the Figure 15 example, it is arranged to provide a desired shape of light intensity distribution with zeroth order light, as illustrated in Figure 15. In this example, substantially all the diffraction lights other than the zeroth order light (diffraction light) are blocked by a light blocking member disposed at the back of the filter.

In the examples of Figures 14 and 15 using a gradation filter and a grating filter, the light intensity distribution may become interrupted. However, in that occasion, a smooth light intensity distribution is still obtainable by shifting the filter by ΔG (Figure 14 or 15) from the optically conjugate position with the reticle 9. In the case of complicated light intensity distribution shape such as these examples, the width S₁ may be an approximated one.

Furthermore, a desired shape of light intensity distribution is obtainable by selecting the general shape of secondary light sources in the vicinity of the light exit surface of the fly's eye lens (such as out of circular, oblong, square, polygonal or a combination of any of them, for example).

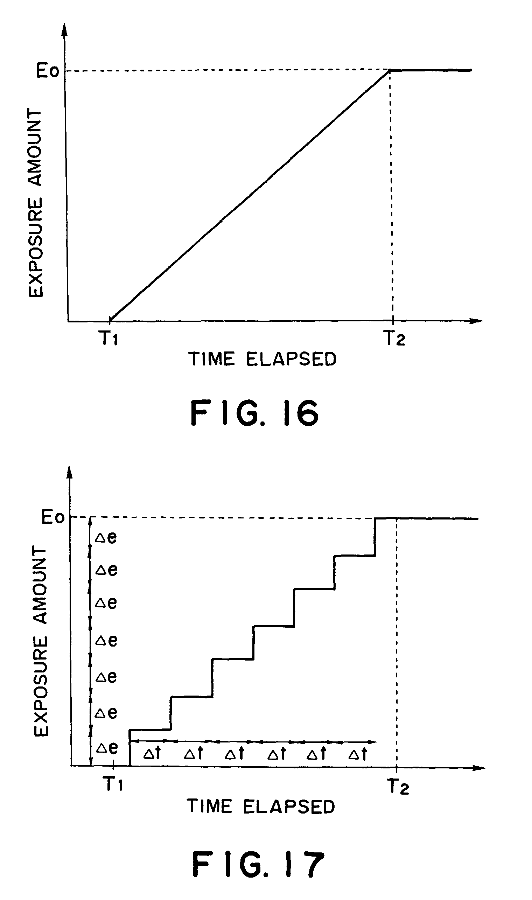

Referring now to Figures 16 - 19, Figure 16 illustrates that the integrated exposure amount at a certain point (point a in this example) on the wafer 11 increases with the movement of the wafer 11. Reference character E₀ denotes the target integration exposure amount. T₁ denotes the moment as the point a comes to the position a₁ (Figure 3), that is, the moment as the point enters the illumination region (the moment of start of exposure). T₂ denotes the moment as the point a comes to the position a₂, that is, the moment as the point goes out the illumination region (the moment of end of exposure).

In a case where a continuous emission type light source such as a Hg lamp is used as an exposure light source, the exposure amount increases continuously from the start of exposure to the end of exposure, such as shown in Figure 16. Thus, by determining the scan speed, the projection energy amount per unit time and the width of the illumination region beforehand and by performing the exposure process while keeping them constant, correct exposure control without exposure non-uniformness may be provided. Also, in a case where pulse light is used as the exposure light as in the present invention and if the projection energy amount per pulse is fixed constant, correct exposure control without exposure non-uniformness may be provided such as illustrated in Figure 17, like the case where a continuous emission type light source is used.

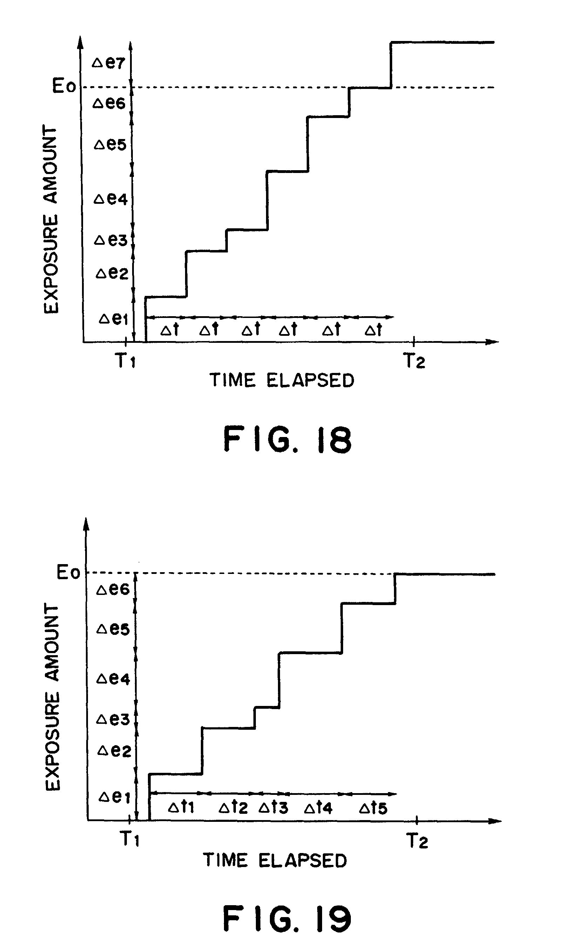

However, as regards pulse light sources such as an excimer laser, while it is possible to maintain the light emission frequency constant, it is not easy to keep the pulse light energy exactly constant. Thus, even if the exposure process is performed exactly in accordance with the conditions as calculated from an average projection energy amount per pulse (e.g., in terms of the setting of energy, illumination slit width; scan speed of a reticle and a wafer, light emission frequency), correct exposure control is not attainable such as illustrated in Figure 18, because of variation or shift of energy of each light pulse. This causes exposure non-uniformness particularly when the exposure process is to be performed in a substantially constant period as in the case of a scan type exposure apparatus.

Figure 19 is a graph for explaining the exposure amount control according to an embodiment of the present invention. In this embodiment, the scan speed of the reticle 9 and the wafer 11 is kept constant, and the exposure amount provided by light pulses sequentially supplied during the scanning exposure is monitored through the light quantity detector 12. If the exposure amount provided by a certain light pulse is larger than a desired exposure amount, the timing of emission of a subsequent light pulse is retarded, under the control of the control system 103. If on the other hand the exposure amount provided by a certain light pulse is lower than the desired exposure amount, the timing of emission of a subsequent light pulse is advanced. This effectively reduces the exposure non-uniformness at each point on the wafer 11, even if light pulses have dispersed light quantities.

As regards the initial setting of the light emission frequency, energy dispersion of light pulses should be taken into account and the the frequency should preferably be set at a value not greater than the maximum frequency of the pulse light source. -As an example, if a laser has the energy dispersion of light pulses of ±5% and the maximum frequency of 500Hz, the light emission frequency should initially be set to a level not higher than 500x100/105(Hz) which is approximately equal to 476Hz.

Next, an embodiment of semiconductor device manufacturing method which uses a projection exposure apparatus of Figure 1, will be explained.

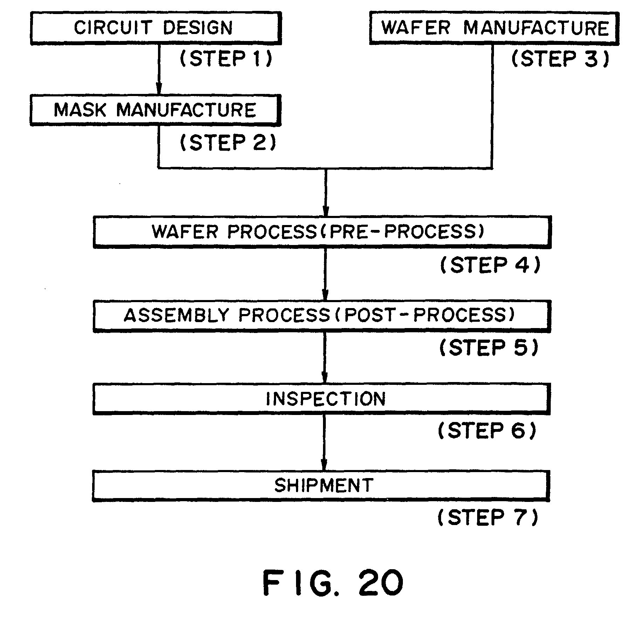

Figure 20 is a flow chart of the sequence of manufacturing a semiconductor device such as a semiconductor chip (e.g. IC or LSI), a liquid crystal panel or a CCD, for example. Step 1 is a design process for designing the circuit of a semiconductor device. Step 2 is a process for manufacturing a mask on the basis of the circuit pattern design. Step 3 is a process for manufacturing a wafer by using a material such as silicon.

Step 4 is a wafer process which is called a pre-process wherein, by using the so prepared mask and wafer, circuits are practically formed on the wafer through lithography. Step 5 subsequent to this is an assembling step which is called a post-process wherein the wafer processed by step 4 is formed into semiconductor chips. This step includes assembling (dicing and bonding) and packaging (chip sealing). Step 6 is an inspection step wherein operability check, durability check and so on of the semiconductor devices produced by step 5 are carried out. With these processes, semiconductor devices are finished and they are shipped (step 7).

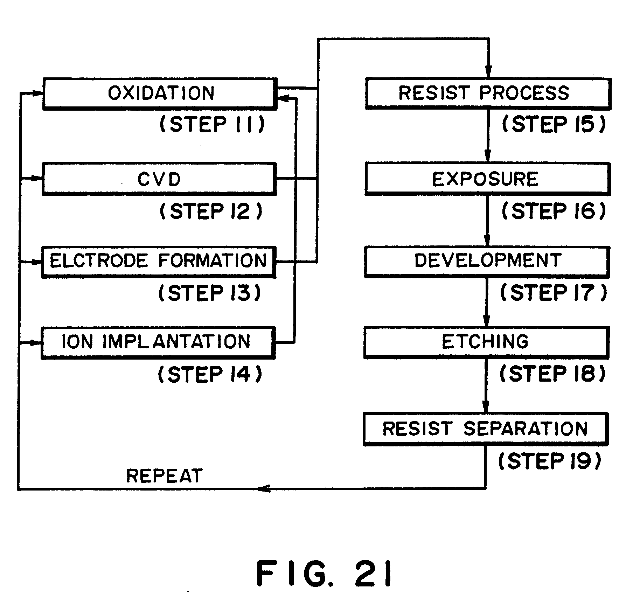

Figure 21 is a flow chart showing details of the wafer process. Step 11 is an oxidation process for oxidizing the surface of a wafer. Step 12 is a CVD process for forming an insulating film on the wafer surface. Step 13 is an electrode forming process for forming electrodes on the wafer by vapor deposition. Step 14 is an ion implanting process for implanting ions to the wafer. Step 15 is a resist process for applying a resist (photosensitive material) to the wafer. Step 16 is an exposure process for printing, by exposure, the circuit pattern of the mask on the wafer through the exposure apparatus described above. Step 17 is a developing process for developing the exposed wafer. Step 18 is an etching process for removing portions other than the developed resist image. Step 19 is a resist separation process for separating the resist material remaining on the wafer after being subjected to the etching process. By repeating these processes, circuit patterns are superposedly formed on the wafer.

While the invention has been described with reference to the structures disclosed herein, it is not confined to the details set forth and this application is intended to cover such modifications or changes within the scope of the following claims.

## Claims

1. An illumination system for relatively and scanningly moving an article to be illuminated (9, 11) relative to an illumination region (105) defined by a pulse light, characterised in that:
in the light intensity distribution defined in the illumination region (105) with respect to the scan direction, the light intensity changes non-linearly from at least one end portion (P₁) to a highest light intensity point (P₄, P₅) in the distribution, wherein the light intensity distribution includes a first point (P₁) at said one end portion, a second point (P₂) whereat light intensity increase changes, a third point (P₃) whereat light intensity increase changes, and a fourth point (P₄) whereat the light intensity is highest, and wherein at least one of the width Wa between the first (P₁) and second (P₂) points and the width Wb between the third (P₃) and fourth (P₄) points substantially corresponds to or is greater than the relative movement amount between the illumination region and the article per pulse.

2. A system according to claim 1, wherein the light intensity distribution has a symmetrical shape with respect to the scan direction.

3. A system according to claim 1 or 2, wherein the second (P₂) and third (P₃) points are coincident with each other.

4. A system according to any of claims 1 - 3 wherein the widths Wa and Wb are equal to each other.

5. A system according to any one of claims 1 - 4, wherein the portions of the light intensity distribution corresponding to the widths Wa and Wb are able to be approximated by a quadratic curve.

6. A system according to any one of claims 1 - 5, further characterised by a masking blade (6) disposed at a position out of a plane which is optically conjugate with the article (9).

7. A system according to any one of claims 1 - 5, further characterised by a filter for determining the light intensity distribution in the illumination region (105).

8. A system according to claim 7, wherein said filter is disposed at a position slightly deviated from a plane which is optically conjugate with the article (9).

9. A system according to claim 7 or 8, wherein said filter has a transmissivity changing with the position of light incidence on said filter.

10. A system according to Claim 7 or 8, wherein said filter comprises a diffraction grating adapted to provide zeroth order diffraction light whose light intensity changes with the position of light incidence on said grating.

11. A system according to Claim 10, further characterized by blocking means for blocking diffraction light other than the zeroth order diffraction light.

12. A system according to any one of Claims 1 - 11, further characterized by control means (103) for controlling the emission time moment of a light pulse on the basis of the light quantity provided by a preceding light pulse.

13. A system according to any one of Claims 1 - 12, wherein the pulse light comprises excimer laser light.

14. A scan type exposure apparatus which includes an illumination system as defined in any one of Claims 1 - 13.

15. A device manufacturing method for manufacturing a device by using an illumination system as defined in any one of Claims 1 - 13.

16. An illumination system for relatively and scanningly moving an article to be illuminated (9, 11) relative to an illumination region(105) to be defined by a pulse light, characterized in that:
a light intensity distribution defined in the illumination region (105) with respect to a scan direction has a trapezoid like shape in which the light intensity at at least one of four corners changes along a smooth curve, wherein the width of at least one portion of the light intensity distribution in which the light intensity changes along a smooth curve corresponds to or is greater than the relative movement amount between the illumination region (105) and the article (11) per pulse.

17. A system according to Claim 16, wherein the light intensity distribution has a symmetrical shape with respect to the scan direction.

18. A system according to Claim 16 or 17, wherein portions of the light intensity distribution in which the light intensity changes along a smooth curve have the same width.

19. A system according to any one of Claims 16 - 18, wherein the portions of the light intensity distribution in which the light intensity changes along a smooth curve are able to be approximated by a quadratic curve.

20. A system according to any one of Claims 16 - 19, further characterized by a masking blade (6) disposed at a position out of a plane which is optically conjugate with the article (9).

21. A system according to any one of Claims 16 - 19, further characterized by a filter for determining the light intensity distribution in the illumination region (105).

22. A system according to Claim 21, wherein said filter is disposed at a position slightly deviated from a plane which is optically conjugate with the article (9).

23. A systemaccording to Claim 21 or 22, wherein said filter has a transmissivity changing with the position of light incidence on said filter.

24. A system according to Claim 21 or 22, wherein said filter comprises a diffraction grating adapted to provide zeroth order diffraction light whose light intensity changes with the position of light incidence on said grating.

25. A system according to Claim 24, further characterized by blocking means for blocking diffraction light other than the zeroth order diffraction light.

26. A system according to any one of Claims 16 - 25, further characterized by control means (103) for controlling the emission time moment of a light pulse on the basis of the light quantity provided by a preceding light pulse.

27. A system according to any one of Claims 16 - 26, wherein the pulse light comprises excimer laser light.

28. A scan type exposure apparatus which includes an illumination system as defined in any one of Claims 16 - 27.

29. A device manufacturing method for manufacturing a device by using an illumination system as defined in any one of Claims 16-27.

## Patentansprüche

1. Beleuchtungssystem zur relativen und abtastenden Bewegung eines zu beleuchtenden Gegenstandes (9, 11) relativ zu einer Beleuchtungsregion (105), die durch ein Pulslicht definiert ist,
**dadurch gekennzeichnet, daß**
sich in der Lichtintensitätsverteilung, die in der Beleuchtungsregion (105) hinsichtlich der Abtastrichtung definiert ist, die Lichtintensität von zumindest einem Endabschnitt (P₁) zu einem höchsten Lichtintensitätspunkt (P₄, P₅) in der Verteilung nicht linear verändert, wobei die Lichtintensitätsverteilung einen ersten Punkt (P₁) bei dem einen Endabschnitt, einen zweiten Punkt (P₂), bei dem sich die Lichtintensitätszunahme verändert, einen dritten Punkt (P₃), bei dem sich die Lichtintensitätszunahme verändert, und einen vierten Punkt (P₄), bei dem die Lichtintensität am höchsten ist, aufweist, und wobei zumindest eine Breite der Breite Wa zwischen dem ersten (P₁) und dem zweiten (P₂) Punkt und der Breite Wb zwischen dem dritten (P₃) und vierten (P₄) Punkt im wesentlichen dem relativen Bewegungsausmaß zwischen der Beleuchtungsregion und dem Artikel pro Puls entspricht oder größer als dieses ist.

2. System nach Anspruch 1, wobei die Lichtintensitätsverteilung eine symmetrische Form hinsichtlich der Abtastrichtung hat.

3. System nach Anspruch 1 oder 2, wobei die zweiten (P₂) und dritten (P₃) Punkte miteinander koinzidieren.

4. System nach einem der Ansprüche 1 bis 3, wobei die Breiten Wa und Wb gleich groß sind.

5. System nach einem der Ansprüche 1 bis 4, wobei die Abschnitte der Lichtintensitätsverteilung gemäß den Breiten Wa und Wb eine quadratische Kurve nähern können.

6. System nach einem der Ansprüche 1 bis 5, ferner
**gekennzeichnet durch**
eine maskierende Lamelleneinrichtung (6), die sich an einer Position außerhalb einer Ebene befindet, die mit dem Gegenstand (9) optisch konjugiert ist.

7. System nach einem der Ansprüche 1 bis 5, ferner
**gekennzeichnet durch**
ein Filter zur Bestimmung der Lichtintensitätsverteilung in der Beleuchtungsregion (105).

8. System nach Anspruch 7, wobei sich das Filter an einer leicht von einer Ebene verschobenen Position befindet, die mit dem Gegenstand (9) optisch konjugiert ist.

9. System nach Anspruch 7 oder 8, wobei das Filter eine Durchlässigkeit aufweist, die sich mit der Position des Lichteinfalls auf dem Filter verändert.

10. System nach Anspruch 7 oder 8, wobei das Filter ein Beugungsgitter aufweist, das geeignet ist, Beugungslicht nullter Ordnung bereitzustellen, dessen Lichtintensität sich mit der Position des Lichteinfalls auf dem Gitter verändert.

11. System nach Anspruch 10, ferner
**gekennzeichnet durch**
eine Blockiereinrichtung zur Blockierung von anderem Beugungslicht als dem Beugungslicht nullter Ordnung.

12. System nach einem der Ansprüche 1 bis 11, ferner
**gekennzeichnet durch**
eine Steuereinrichtung (103) zur Steuerung des Emissionszeitpunktes eines Lichtpulses auf der Grundlage der Lichtmenge, die von einem vorhergehenden Lichtpuls bereitgestellt wird.

13. System nach einem der Ansprüche 1 bis 12, wobei das Pulslicht Excimerlaserlicht aufweist.

14. Abtasttyp-Belichtungsgerät, das ein Beleuchtungssystem nach einem der Ansprüche 1 bis 13 aufweist.

15. Vorrichtungs-Herstellungsverfahren zur Herstellung einer Vorrichtung unter Verwendung eines Beleuchtungssystems nach einem der Ansprüche 1 bis 13.

16. Beleuchtungssystem zur relativen und abtastenden Bewegung eines zu beleuchtenden Gegenstands (9, 11) relativ zu einer Beleuchtungsregion (105), die durch ein Pulslicht zu definieren ist,
**dadurch gekennzeichnet, daß:**
eine in der Beleuchtungsregion (105) hinsichtlich einer Abtastrichtung definierte Lichtintensitätsverteilung eine trapezartige Form aufweist, in der sich die Lichtintensität an zumindest einer von vier Ecken entlang einer glatten Kurve verändert, wobei die Breite von zumindest einem Abschnitt der Lichtintensitätsverteilung, in dem sich die Lichtintensität entlang einer glatten Kurve verändert, dem relativen Bewegungsausmaß zwischen der Beleuchtungsregion (105) und dem Gegenstand (11) pro Puls entspricht oder größer als dieses ist.

17. System nach Anspruch 16, wobei die Lichtintensitätsverteilung eine symmetrische Form hinsichtlich der Abtastrichtung aufweist.

18. System nach Anspruch 16 oder 17, wobei Abschnitte der Lichtintensitätsverteilung, in denen sich die Lichtintensität entlang einer glatten Kurve verändert, dieselbe Breite haben.

19. System nach einem der Ansprüche 16 bis 18, wobei die Abschnitte der Lichtintensitätsverteilung, in denen sich die Lichtintensität entlang einer glatten Kurve verändert, von einer quadratischen Kurve genähert werden können.

20. System nach einem der Ansprüche 16 bis 19, ferner
**gekennzeichnet durch**
eine maskierende Lamelleneinrichtung (6), die sich an einer Position außerhalb einer Ebene befindet, die mit dem Gegenstand (9) optisch konjugiert ist.

21. System nach einem der Ansprüche 16 bis 19, ferner
**gekennzeichnet durch**
ein Filter zur Bestimmung der Lichtintensitätsverteilung in der Beleuchtungsregion (105).

22. System nach Anspruch 21, wobei sich das Filter an einer Position befindet, die leicht von einer Ebene verschoben ist, die mit dem Gegenstand (9) optisch konjugiert ist.

23. System nach Anspruch 21 oder 22, wobei das Filter eine Durchlässigkeit aufweist, die sich mit der Position des Lichteinfalls auf dem Filter verändert.

24. System nach Anspruch 21 oder 22, wobei das Filter ein Beugungsgitter aufweist, das geeignet ist, Beugungslicht nullter Ordnung bereitzustellen, dessen Lichtintensität sich mit der Position des Lichteinfalls auf dem Gitter verändert.

25. System nach Anspruch 24, ferner
**gekennzeichnet durch**
eine Blockiereinrichtung zum Blockieren von anderem Beugungslicht als dem Beugungslicht nullter Ordnung.

26. System nach einem der Ansprüche 16 bis 25, ferner
**gekennzeichnet durch**
eine Steuereinrichtung (103) zur Steuerung des Emissionszeitpunktes eines Lichtpulses auf der Grundlage der Lichtmenge, die von einem vorhergehenden Lichtpuls bereitgestellt wird.

27. System nach einem der Ansprüche 16 bis 26, wobei das Pulslicht Excimerlaserlicht aufweist.

28. Abtasttyp-Belichtungsgerät, das ein Beleuchtungssystem nach einem der Ansprüche 16 bis 27 aufweist.

29. Vorrichtungs-Herstellungsverfahren zur Herstellung einer Vorrichtung unter Verwendung eines Beleuchtungssystems nach einem der Ansprüche 16 bis 27.

## Revendications

1. Système d'illumination pour déplacer de façon relative et par balayage un article devant être illuminé (9, 11) par rapport à une région d'illumination (105) définie par une lumière pulsée, caractérisé en ce que :
dans la distribution d'intensité de lumière définie dans la région d'illumination (105) par rapport à la direction de balayage, l'intensité de la lumière change de façon non linéaire à partir d'au moins une première partie extrême (P₁) jusqu'à un point (P₄, P₅) d'intensité lumineuse la plus élevée dans la distribution, la distribution de l'intensité lumineuse comprenant un premier point (P₁) à ladite première partie extrême, un deuxième point (P₂) auquel l'accroissement de l'intensité lumineuse change, un troisième point (P₃) auquel l'accroissement de l'intensité lumineuse change, et un quatrième point (P₄) auquel l'intensité lumineuse est la plus élevée, et dans lequel au moins l'une de la largeur Wa entre les premier (P₁) et deuxième (P₂) points et de la largeur Wb entre les troisième (P₃) et quatrième (P₄) points correspond sensiblement à, ou est supérieur à, l'amplitude du mouvement relatif, par impulsion, entre la région d'illumination et l'article.

2. Système selon la revendication 1, dans lequel la distribution de l'intensité lumineuse présente une forme symétrique par rapport à la direction de balayage.

3. Système selon la revendication 1 ou 2, dans lequel les deuxième (P₂) et troisième (P₃) points coïncident l'un avec l'autre.

4. Système selon l'une quelconque des revendications 1-3, dans lequel les largeurs Wa et Wb sont égales entre elles.

5. Système selon l'une quelconque des revendications 1-4, dans lequel les parties de la distribution de l'intensité lumineuse correspondant aux largeurs Wa et Wb peuvent être données approximativement par une courbe quadratique.

6. Système selon l'une quelconque des revendications 1-5, caractérisé en outre par une lame (6) de masquage disposée en un emplacement en dehors d'un plan qui est optiquement conjugué avec l'article (9).

7. Système selon l'une quelconque des revendications 1-5, caractérisé en outre par un filtre destiné à déterminer la distribution de l'intensité lumineuse dans la région d'illumination (105).

8. Système selon la revendication 7, dans lequel ledit filtre est disposé en un emplacement légèrement dévié d'un plan qui est optiquement conjugué avec l'article (9).

9. Système selon la revendication 7 ou 8, dans lequel ledit filtre présente une transmissivité changeant avec la position d'incidence de la lumière sur ledit filtre.

10. Système selon la revendication 7 ou 8, dans lequel ledit filtre comporte un réseau de diffraction conçu pour produire une lumière de diffraction d'ordre zéro dont l'intensité lumineuse change avec la position d'incidence de la lumière sur ledit réseau.

11. Système selon la revendication 10, caractérisé en outre par un moyen d'arrêt destiné à arrêter la lumière de diffraction autre que la lumière de diffraction d'ordre zéro.

12. Système selon l'une quelconque des revendications 1-11, caractérisé en outre par un moyen de commande (103) destiné à commander l'instant d'émission d'une impulsion de lumière sur la base de la quantité de lumière fournie par une impulsion lumineuse précédente.

13. Système selon l'une quelconque des revendications 1-12, dans lequel l'impulsion de lumière comprend une lumière d'un laser à excimère.

14. Appareil d'exposition du type à balayage qui comprend un système d'illumination tel que défini dans l'une quelconque des revendications 1-13.

15. Procédé de fabrication d'un dispositif pour la fabrication d'un dispositif en utilisant un système d'illumination tel que défini dans l'une quelconque des revendications 1-13.

16. Système d'illumination pour déplacer de façon relative et par balayage un article devant être illuminé (9, 11) par rapport à une région d'illumination (105) devant être définie par une lumière pulsée, caractérisé en ce que :
une distribution d'intensité lumineuse définie dans la région d'illumination (105) par rapport à une direction de balayage présente une forme analogue à un trapèze dans laquelle l'intensité lumineuse en au moins l'un des quatre angles change suivant une courbe douce, dans laquelle la largeur d'au moins une partie de la distribution de l'intensité lumineuse dans laquelle l'intensité lumineuse change suivant une courbe douce correspond à, ou est supérieure à, l'amplitude du mouvement relatif, par impulsion, entre la région d'illumination (105) et l'article (11).

17. Système selon la revendication 16, dans lequel la distribution de l'intensité lumineuse présente une forme symétrique par rapport à la direction de balayage.

18. Système selon la revendication 16 ou 17, dans lequel des parties de la distribution de l'intensité lumineuse, dans lesquelles l'intensité lumineuse change suivant une courbe douce, ont la même largeur.

19. Système selon l'une quelconque des revendications 16-18, dans lequel les parties de la distribution de l'intensité lumineuse, dans lesquelles l'intensité lumineuse change suivant une courbe douce, peuvent être données approximativement par une courbe quadratique.

20. Système selon l'une quelconque des revendications 16-19, caractérisé en outre par une lame de masquage (6) disposée dans une position en dehors d'un plan qui est optiquement conjugué avec l'article (9).

21. Système selon l'une quelconque des revendications 16-19, caractérisé en outre par un filtre destiné à déterminer la distribution de l'intensité lumineuse dans la région d'illumination (105).

22. Système selon la revendication 21, dans lequel ledit filtre est disposé dans une position légèrement déviée d'un plan qui est optiquement conjugué avec l'article (9).

23. Système selon la revendication 21 ou 22, dans lequel ledit filtre possède une transmissivité changeant avec la position d'incidence de la lumière sur ledit filtre.

24. Système selon la revendication 21 ou 22, dans lequel ledit filtre comporte un réseau de diffraction conçu pour établir une lumière de diffraction d'ordre zéro dont l'intensité lumineuse change avec la position d'incidence de la lumière sur ledit réseau.

25. Système selon la revendication 24, caractérisé en outre par un moyen d'arrêt destiné à arrêter la lumière de diffraction autre que la lumière de diffraction d'ordre zéro.

26. Système selon l'une quelconque des revendications 16-25, caractérisé en outre par un moyen de commande (103) destiné à commander l'instant d'émission d'une impulsion de lumière sur la base de la quantité de lumière fournie par une impulsion de lumière précédente.

27. Système selon l'une quelconque des revendications 16-26, dans lequel la lumière pulsée comprend une lumière d'un laser à excimère.

28. Appareil d'exposition du type à balayage qui comprend un système d'illumination tel que défini dans l'une quelconque des revendications 16-27.

29. Procédé de fabrication d'un dispositif pour la fabrication d'un dispositif en utilisant un système d'illumination tel que défini dans l'une quelconque des revendications 16-27.
